(19)

Europäisches
Patentamt
European
Patent Office
Office européen
des brevets

(11) **EP 1 798 308 A2**

(12) **EUROPEAN PATENT APPLICATION**

(43) Date of publication:
**20.06.2007 Bulletin 2007/25**

(21) Application number: **06125329.0**

(22) Date of filing: **04.12.2006**

(51) Int Cl.:
*C23C 28/00* (2006.01)    *C23C 14/06* (2006.01)
*C23C 14/18* (2006.01)    *C23C 14/32* (2006.01)
*C23C 14/34* (2006.01)

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.12.2005 SE 0502747**

(71) Applicant: **Sandvik Intellectual Property AB 811 81 Sandviken (SE)**

(72) Inventors:
• **Martensson, Malin SE 131 33 Nacka (SE)**

• **Ahlgren, Mats SE 187 67 Täby (SE)**
• **Nordgren, Anders SE 121 34 Enskede (SE)**
• **Wahlquist, Kerstin SE 117 67 Stockholm (SE)**
• **Åstrand, Maria SE 191 34 Sollentuna (SE)**

(74) Representative: **Taquist, Henrik Lennart Emanuel Sandvik Intellectual Property AB 811 81 Sandviken (SE)**

(54) **Cemented carbide inserts for notch and wear demanding turning in heat resistant super alloys (HRSA) and stainless steels**

(57)    The present invention relates to a cutting insert for turning in heat resistant super alloys and stainless steels comprising a substrate and a coating. The substrate consists of WC 5-7 wt-% Co and 0.15-0.60 wt-% TaC and 0.10-0.50 wt-% NbC and balance WC, has a coercivity of 19.5-24.5 kA/m and a CW-ratio between 0.85-1.00. The coating comprises a homogeneous $Al_xTi_{1-x}N$-layer with x=0.6-0.7 and a thickness of >1 $\mu$m but <3.8 $\mu$m.

Fig. 1

EP 1 798 308 A2

**Description**

The present invention relates to a coated cutting tool insert particularly useful for turning of heat resistant super alloys and stainless steels. A thin PVD-coating greatly improves the flank wear resistance and the notch wear resistance both on the leading and secondary edge and a fine grained substrate provides good resistance against plastic deformation.

Turning of super alloys can generally be divided in roughing, semi-roughing, semi-finishing and finishing. In roughing and semi-roughing the depth of cut is larger than the nose radius and notch wear on both the leading and the secondary edge is the dominant wear mechanism. In semi-finishing and finishing, the depth of cut is smaller than the nose radius and the flank wear and crater wear dominate.

The wear of the secondary edges is an important parameter since it affects the quality of the machined surface.

It is an object of the present invention to provide a cutting tool insert particularly useful for turning in heat resistant super alloys and stainless steels.

It is a further object of the present invention to provide a cutting tool insert with improved wear resistance of the secondary edge.

It has now surprisingly been found that a relatively thin PVD-coating greatly improves the flank wear resistance and the notch wear resistance both on the leading and secondary edge and a fine grained substrate provides good resistance against plastic deformation when turning in heat resistant super alloys and stainless steels. The wear on the secondary cutting edge increases with coating thickness. When the coating thickness exceeds about 4 $\mu$m the wear escalates on the secondary edge.

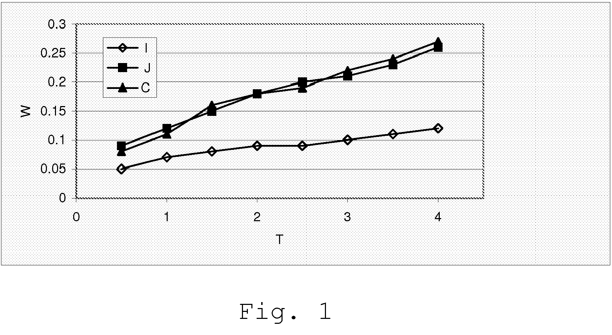

Figure 1 shows the wear on the secondary edge over time for inserts according to the invention (un-filled diamonds), outside invention (filled squares) and prior art (filled triangles).

The present invention thus relates to a coated cutting tool insert of a cemented carbide substrate and a coating. The cemented carbide substrate consists of 5-7 wt-% Co, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, preferably 0.10-0.20 wt-% NbC and balance WC. The cemented carbide body may also contain smaller amounts of other elements, but then at a level corresponding to a technical impurity. The coercivity is 19.5-24.5 kA/m.

The cobalt binder phase is alloyed with a certain amount of W giving the invented cemented carbide cutting insert its desired properties. W in the binder phase influences the magnetic properties of cobalt and can hence be related to a CW-ratio, defined as

$$CW= \text{magnetic-\% Co} \ / \ \text{wt-\% Co}$$

where magnetic-% Co is the weight percentage of magnetic Co and wt-% Co is the weight percentage of Co in the cemented carbide.

The CW-ratio can vary between 1 and about 0.75 dependent on the degree of W-alloying. A lower CW-ratio correspond to higher W contents and CW-ratio =1 corresponds practically to an absence of W in the binder phase.

It has been found according to the present invention that improved cutting performance is achieved if the cemented carbide body has a CW-ratio between 0.85-1.00, preferably 0.9-0.98, most preferably 0.92-0.97.

The coating comprises a homogeneous coating $Al_xTi_{1-x}N$ with x=0.6-0.67, preferably x=0.62. The total thickness of the layer is >1 $\mu$m, preferably >1.8 $\mu$m but <3.8 $\mu$m, preferably <3.0 $\mu$m. Both the composition and the thickness are measured on the flank face 1 mm from the nose radius and 200 $\mu$m from the cutting edge.

The present invention also relates to a method of making a coated cutting tool insert consisting of a cemented carbide substrate and a coating. The cemented carbide substrate is made using conventional powder metallurgical techniques milling, pressing and sintering and consists of 5-7 wt-% of Co, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, more preferably 0.10-0.20 wt-% NbC and balance WC. The cemented carbide body may also contain smaller amounts of other elements, but then on a level corresponding to a technical impurity. The coercivity is 19.5 - 24.5 kA/m.

The CW-ratio is between 0.85-1.00, preferably 0.9-0.98, most preferably 0.92-0.97 and the CW-ratio is monitored by adding suitable amounts of carbon black or tungsten powder to the powder mixture.

After conventional post sintering treatment, such as blasting or grinding, a coating comprising $Al_xTi_{1-x}N$ with x=0.6-0.67, preferably x=0.62 is deposited by cathodic arc evaporation using a target material consisting of TiAl-alloy of suitable composition, in a $N_2$ gas atmosphere. The total thickness of the coating is >1 $\mu$m, preferably >1.8 $\mu$m but <3.8 $\mu$m, preferably <3.0 $\mu$m.

The present invention also relates to the use of the insert according to above for turning in heat resistant super alloys and stainless steels as Inconel 718, Inconel 625, Waspaloy, Udimet 720, San-Mac 316L, SAF2205, SAF2507 at a cutting speed of 30-180 m/min and a feed of 0.1-0.4 mm/rev.

Example 1

A homogeneous (Ti,Al)N coating was deposited by cathodic arc evaporation on turning inserts made of cemented carbide with composition of 6 wt-% Co, 0.16 wt-% NbC, 0.23 wt-% TaC and balance WC and a coercivity of 22.4 kA/m and a CW-ratio of 0.96. The coating was deposited using a target material consisting of $Ti_{33}Al_{67}$ alloy. The arc evaporation was performed in a $N_2$ gas atmosphere. The resulting total coating thickness was 2.5 $\mu$m, and consisted of a homogeneous $Al_{62}Ti_{38}N$ layer.

Example 2

Example 1 was repeated with the important difference that the deposition time was chosen to obtain a layer thickness of 4.5 $\mu$m.

Example 3

A. Cemented carbide turning inserts in accordance with the invention with the composition 6 wt-% Co, 0.16 wt-% NbC, 0.23 wt-% TaC and balance WC and a coercivity of 22.4 kA/m and with a binder phase alloyed with W corresponding to a CW-ratio of 0.96 were coated with a 2.9 $\mu$m (Ti,Al)N PVD-coating.
B. Commercial cemented carbide with the composition of 6 wt-% Co, 0.5 wt-% $Cr_3C_2$ and balance WC and with a coercivity of 23.8 kA/m and a CW-ratio of 0.85. The inserts were coated with a 2.9 $\mu$m (Ti,Al)N PVD-coating.

Inserts from A and B were tested in turning of a cast, Inconel 718 bearing house.

| | |
|---|---|
| Operation: | Turning/facing - roughing |
| Work-piece: | Bearing house |
| Material: | Inconel 718 in cast and aged condition |
| Cutting speed: | 34 m/min |
| Feed rate: | 0.175 mm/rev |
| Depth of cut: | 1.78 mm |
| Insert-style: | CNMG120408 |
| Note: | Turning with coolant |

Results: Flank wear on secondary cutting edge after 7.2 minutes of machining

| | | |
|---|---|---|
| Grade A: | (invention) | 0.05 mm |
| Grade B: | (prior art) | 0.20 mm |

Tool change after two components (pre-determined) corresponding to 7.2 minutes of machining.

Example 4

C. Commercial cemented carbide with the composition of 6 wt-% Co, 0.16 wt-% NbC, 0.23 wt-% TaC and balance WC with a coercivity of 23.1 kA/m and a CW-ratio of 0.93. The inserts were coated with a 4.3 $\mu$m PVD (Ti,Al)N multilayer coating.

Inserts from A and C were tested in turning of a Inconel 718 gate spring retainer.

| | |
|---|---|
| Operation: | Turning - roughing |
| Work-piece: | Gate spring retainer |
| Material: | Inconel 718 in forged and aged condition |
| Cutting speed: | 30 m/min |

(continued)

| | |
|---|---|
| Feed rate: | 0.2 mm/rev |
| Depth of cut: | 2.5 mm |
| Insert-style: | CNMG120412 |
| Note: | Turning with coolant |

Results: Flank wear along main cutting edge after one component

| | |
|---|---|
| Grade A: (invention) | 0.05 mm |
| Grade C: (prior art) | 0.10 mm |

Tool change after one component (pre-determined).

Example 5

D. Cemented carbide turning inserts in accordance with the invention with the composition 6 wt-% Co, 0.16 wt-% NbC, 0.23 wt-% TaC and balance WC and with a coercivity of 24.0 kA/m and a CW-ratio of 0.93 were coated with a 2.6 $\mu$m (Ti,Al)N PVD-coating.
E. Commercial cemented carbide with the composition of 6 wt-% Co, 0.5 wt-% $Cr_3C_2$ and balance WC and with a coercivity of 22.0 kA/m and a CW-ratio = 0.82. The inserts were coated with a 5.2 $\mu$m (Ti,Al)N PVD-coating.

Inserts from D and E were tested in turning of a Udimet 720 turbine wheel.

| | |
|---|---|
| Operation: | Turning - semi-finishing |
| Work-piece: | Turbine wheel |
| Material: | Udimet 720 in forged and aged condition |
| Cutting speed: | 46 m/min |
| Feed rate: | 0.075-0.15 mm/rev |
| Depth of cut: | 1 mm |
| Insert-style: | CNGP 120408 |
| Note: | Turning with coolant |

Results: Flank wear along secondary edge after one component

| | |
|---|---|
| Grade D: (invention) | 0.07 mm |
| Grade E: (prior art) | 0.13 mm |

Tool change after one component (pre-determined) corresponding to 13 minutes of machining.

Example 6

Inserts from B, C and D were tested in turning of a Udimet 720 turbine wheel.

| | |
|---|---|
| Operation: | Turning - semi-finishing |
| Work-piece: | Turbine wheel |
| Material: | Udimet 720 in forged and aged condition |
| Cutting speed: | 46-55 m/min |
| Feed rate: | 0.075-0.125 mm/rev |
| Depth of cut: | 0.25-1 mm |
| Insert-style: | CNGP 120408, CNGG 120408 |
| Note: | Turning with coolant |

Results: Flank wear along main cutting edge after one component

| | |
|---|---|
| Grade D: (invention) | 0.04 mm |
| Grade C: (prior art) | 0.09 mm |
| Grade B: (prior art) | 0.17 mm |

Tool change after one component (pre-determined) corresponding to 23.7 minutes of machining.

Example 7

Inserts from B, D and E were tested in turning of a Udimet 720 turbine wheel.

| | |
|---|---|
| Operation: | Turning - finishing |
| Work-piece: | Turbine wheel |
| Material: | Udimet 720 in forged and aged condition |
| Cutting speed: | 46 m/min |
| Feed rate: | 0.125 mm/rev |
| Depth of cut: | 0.38 mm |
| Insert-style: | CNGP 120408, CNGG 120408 |
| Note: | Turning with coolant |

Results: Flank wear along main cutting edge after one component

| | |
|---|---|
| Grade D: (invention) | 0.05 mm |
| Grade E: (prior art) | 0.10 mm |
| Grade B: (prior art) | 0.10 mm |

Tool change after one component (pre-determined) corresponding to 5 minutes of machining.

Example 8

Inserts from C and D were tested in turning of a Inconel 718 bar.

| | |
|---|---|
| Operation: | Turning - roughing |
| Work-piece: | Forged and machined bar |
| Material: | Inconel 718 in forged and aged condition |
| Cutting speed: | 50 m/min |
| Feed rate: | 0.25 mm/rev |
| Depth of cut: | 1 mm |
| Insert-style: | CNMG 120408 |
| Note: | Turning with coolant |

Results: Tool life, minutes of cut

| | |
|---|---|
| Grade D: (invention) | 5.2 min |
| Grade C: (prior art) | 3 min |

Tool-life criterion was notch wear on main cutting edge 0.3 mm

Example 9

F. Commercial cemented carbide with the composition of 5.8 wt-% Co, 0.5 wt-% $Cr_3C_2$ and balance WC and with a coercivity of 19.8 kA/m and a CW-ratio of 0.83. The inserts were coated with a 1.3 μm (Ti,Al)N PVD coating.

Inserts from D, E and F were tested in turning of a Udimet 720 turbine wheel.

| | |
|---|---|
| Operation: | Turning - finishing |
| Work-piece: | Turbine wheel |
| Material: | Udimet 720 in forged and aged condition |
| Cutting speed: | 46 m/min |
| Feed rate: | 0.15 mm/rev |
| Depth of cut: | 0.1-0.5 mm |
| Insert-style: | CNGP 120408, CNGG 120408 |
| Note: | Turning with coolant |

Results: Flank wear along secondary edge after one component

| | |
|---|---|
| Grade D: (invention) | 0.07 mm |
| Grade E: (prior art) | 0.15 mm |
| Grade F: (prior art) | 0.15 mm |

Tool change after one component (pre-determined) corresponding to 8.3 minutes of machining.

Example 10

G. Cemented carbide turning inserts in accordance with the invention with the composition of 6 wt-% Co, 0.16 wt-% NbC, 0.23 wt-% TaC and balance WC and a coercivity of 24.0 kA/m and a CW-ratio of 0.93 were coated with a 2.6 μm (Ti,Al)N PVD-coating.

Inserts from C, E and G were tested in turning of a Inconel 718 casing.

| | |
|---|---|
| Operation: | Turning - Finishing |
| Work-piece: | Casing |
| Material: | Inconel 718 in forged and aged condition |
| Cutting speed: | 37 m/min |
| Feed rate: | 0.2 mm/rev |
| Depth of cut: | 0.25 mm |
| Insert-style: | CNMG 120408 |
| Note: | Turning with coolant |

Results: Flank wear along secondary edge after one component

| | |
|---|---|
| Grade G: (invention) | 0.06 mm |
| Grade E: (prior art) | 0.17 mm |
| Grade C: (prior art) | 0.22 mm |

Tool change after one component (pre-determined) corresponding to 9.7 minutes of machining.

Example 11

H. Cemented carbide turning inserts in accordance with the invention with the composition 6 wt-% Co, 0.16 wt-% NbC, 0.23 wt-% TaC and balance WC and with a coercivity of 21.6 kA/m and a CW-ratio of 0.95 were coated with a 2.7 $\mu$m (Ti,Al)N PVD-coating.

Inserts from C and H were tested in turning of an Inconel 718 bar.

| | |
|---|---|
| Operation: | Turning - semi-finishing |
| Work-piece: | Forged and machined bar |
| Material: | Inconel 718 in forged and aged condition |
| Cutting speed: | 70 m/min |
| Feed rate: | 0.15 mm/rev |
| Depth of cut: | 0.5 mm |
| Insert-style: | CNGP 120408 |
| Note: | Turning with coolant |

Results: Tool life, minutes of cut

| | |
|---|---|
| Grade H: (invention) | 5 min |
| Grade C: (prior art) | 2.5 min |

Tool-life criterion was notch wear on main cutting edge 0.3 mm

Example 12

I. Cemented carbide turning inserts in accordance with the invention with the composition 6 wt-% Co, 0.16 wt-% NbC, 0.23 wt-% TaC and WC and average WC grain size of 1.2 $\mu$m, and with a coercivity of 22.0 kA/m and a CW-ratio of 0.97 were coated with a 2.4 $\mu$m thick (Ti,Al)N PVD-coating.

Inserts from B, C and I were tested in turning of an Inconel 718 bar.

| | |
|---|---|
| Operation: | Turning - roughing |
| Work-piece: | Forged and machined bar |
| Material: | Inconel 718 in forged and aged condition |
| Cutting speed: | 50 m/min |
| Feed rate: | 0.2 mm/rev |
| Depth of cut: | 1.5 mm |
| Insert-style: | CNMG 120408 |
| Note: | Turning with coolant |

Results: Tool life, minutes of cut

| | |
|---|---|
| Grade I: (invention) | 5.5 min |
| Grade B: (prior art) | 4.5 min |
| Grade C: (prior art) | 3.2 min |

Tool-life criterion was notch wear=0.3 mm on main cutting edge

Example 13

J. Cemented carbide turning inserts in accordance with the invention with the same composition as grade I but coated with a 4.7 $\mu$m thick (Ti,Al)N PVD-coating.

Inserts from Grade I (invention), Grade J and Grade C (prior art) were tested in turning of an Inconel 718 bar.

| Operation: | Turning - roughing |
|---|---|
| Work-piece: | Forged and machined bar |
| Material: | Inconel 718 in forged and aged condition |
| Cutting speed: | 50 m/min |
| Feed rate: | 0.2 mm/rev |
| Depth of cut: | 1.5 mm |
| Insert-style: | CNMG 120408 |
| Note: | Turning with coolant |

Results: Flank wear on secondary cutting edge after 4 minutes of machining.

| Grade I: (invention) | 0.12 mm |
|---|---|
| Grade J: (outside invention) | 0.26 mm |
| Grade C: (prior art) | 0.26 mm |

The diagram in Fig 1 shows the maximum flank wear on the secondary edge over time, where W is the maximum wear on the secondary edge in mm and T is the time in cut in minutes. The unfilled diamonds denote grade I (invention), the filled squares denote grade J (outside invention) and the filled triangles denote grade C (prior art).

**Claims**

1. Cutting tool insert for turning of heat resistant super alloys and stainless steels comprising a substrate and a coating **characterised in that** said substrate consists of 5-7, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, preferably 0.10-0.20 wt-% NbC and balance WC, a coercivity of 19.5-24.5 kA/m, a CW-ratio between 0.85-1.00, preferably 0.9-0.98, most preferably 0.92-0.97 and **in that** said coating comprises a homogeneous $Al_xTi_{1-x}N$-layer with x=0.6-0.67, preferably x=0.62 and a thickness of >1 $\mu$m, preferably >1.8 $\mu$m but <3.8 $\mu$m, preferably <3.0 $\mu$m.

2. Method of making a coated cutting tool insert for turning of heat resistant super alloys and stainless steels consisting of a cemented carbide substrate and a coating **characterised by** producing the substrate by using conventional powder metallurgical techniques milling, pressing and sintering, the substrate consists of 5-7 wt-% Co, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, preferably 0.10-0.20 wt-% NbC and balance WC with coercivity of 19.5-24.5 kA/m and a CW-ratio between 0.85-1.00, preferably 0.9-0.98, most preferably 0.92-0.97 and after conventional post sintering treatment, depositing a coating comprising $Al_xTi_{1-x}N$ with x=0.6-0.67, preferably x=0.62, by cathodic arc evaporation using a target material consisting of a TiAl-alloy of suitable composition, in an $N_2$ gas atmosphere whereby the total thickness of the coating is >1 $\mu$m, preferably >1.8 $\mu$m but <3.8 $\mu$m, preferably <3.0 $\mu$m.

3. Use of the insert according to claim 1 for turning of heat resistant super alloys and stainless steels as Inconel 718, Inconel 625, Waspaloy, Udimet 720, San-Mac 316L, SAF2205, SAF2507 at a cutting speed of 30-180 m/min and a feed of 0.1-0.4 mm/rev.

Fig. 1